# FASCICULE DE BREVET EUROPEEN

(11) **EP 3 090 112 B1**
(45) Date de publication et mention de la délivrance du brevet: **10.04.2019**
(21) Numéro de dépôt: 14821217.8
(22) Date de dépôt: 30.12.2014
(51) Int. Cl.: H01L 31/042, E06B 3/66, H02S 20/26, F24F 130/20

(54) **PROCEDE DE FONCTIONNEMENT D'UNE FENETRE ET D'UN SYSTEME DOMOTIQUE POUR BATIMENT**
VERFAHREN ZUR BEDIENUNG EINES FENSTERS UND EINES HAUSTECHNIKSYSTEMS EINES GEBÄUDES
METHOD FOR OPERATING A WINDOW AND A HOME AUTOMATION OF A BUILDING

(30) Priorité: 31.12.2013 FR 1363727
(43) Date de publication de la demande: 09.11.2016
(73) Titulaire: Somfy Activites SA, 74300 Cluses (FR)
(72) Inventeur: ROUSSEAU, Fabien, F-74440 Mieussy (FR); MIGNOT, Pierre, F-05380 Châteauroux les Alpes (FR); CAVAREC, Pierre-Emmanuel, F-74130 Mont Saxonnex (FR)
(74) Mandataire: Novaimo
(86) Numéro de dépôt international: PCT/EP2014/079410
(87) Numéro de publication internationale: WO 2015/101614

(56) Documents cités:
- EP-A1- 1 785 675
- DE-A1- 3 943 516

## Description

L'invention concerne le domaine de la domotique. En particulier, elle concerne un procédé de fonctionnement d'une fenêtre intelligente. Elle concerne aussi un procédé de fonctionnement d'un système comprenant une telle fenêtre. L'invention concerne aussi une telle fenêtre de bâtiment ou pour bâtiment et un tel système.

Dans le domaine de l'habitat, les enjeux de consommation d'énergie et d'écologie sont importants. Pour optimiser ces aspects, il a été envisagé d'utiliser des capteurs et/ou des modèles pour estimer les apports et les pertes énergétiques subies par un bâtiment. Toutefois, ces estimations sont généralement difficiles à réaliser. Elles le sont encore plus en temps réel.

Le document DE3943516 décrit une structure de double vitrage comprenant, entre deux vitrages, un isolant et un élément photovoltaïque.

Le but de l'invention est de fournir un procédé remédiant aux inconvénients relevés précédemment et améliorant les procédés connus de l'art antérieur. En particulier, l'invention propose un procédé permettant de déterminer de manière simple, fiable et précise un apport thermique ou flux thermique pénétrant dans un bâtiment.

Selon l'invention, le procédé régit le fonctionnement d'une fenêtre pour bâtiment, la fenêtre comprenant un cadre de vitrage et un vitrage au moins partiellement recouvert d'un film photovoltaïque transparent. Le procédé comprend une étape de détermination d'au moins une valeur d'un paramètre électrique issu du film photovoltaïque et une étape de détermination d'une valeur d'un flux thermique traversant le vitrage de la fenêtre, en utilisant l'au moins une valeur de paramètre électrique.

L'étape de détermination d'au moins une valeur de paramètre électrique peut comprendre la détermination d'une valeur de tension et/ou d'intensité aux bornes du film photovoltaïque ou aux bornes d'une partie du film photovoltaïque.

L'étape de détermination de la valeur du flux thermique traversant le vitrage de la fenêtre peut comprendre une lecture dans une table d'une valeur de flux thermique associée à l'au moins une valeur de paramètre électrique.

L'étape de détermination de la valeur du flux thermique traversant le vitrage de la fenêtre peut comprendre un calcul utilisant l'au moins une valeur de paramètre électrique.

Le procédé peut comprendre une étape d'émission de la valeur du flux thermique déterminée vers un dispositif de gestion thermique du bâtiment, la valeur déterminée de flux thermique étant destinée à être utilisée pour définir un ordre de commande d'un dispositif de chauffage et/ou de climatisation et/ou d'aération et/ou de fermeture et/ou de protection solaire et/ou d'occultation.

L'étape de détermination de la valeur du flux thermique traversant le vitrage de la fenêtre peut utiliser une valeur de température du vitrage ou du film photovoltaïque.

Selon l'invention, le procédé régit le fonctionnement d'un système domotique comprenant un système de gestion thermique d'un bâtiment et une fenêtre comprenant un cadre de vitrage et un vitrage au moins partiellement recouvert d'un film photovoltaïque transparent. Le procédé comprend une étape de détermination d'au moins une valeur d'un paramètre électrique issu du film photovoltaïque, une étape de détermination d'une valeur d'un flux thermique traversant le vitrage de la fenêtre, en utilisant l'au moins une valeur de paramètre électrique, notamment une étape de détermination de la valeur du flux thermique telle que définie dans les paragraphes précédents, et une étape de définition d'un ordre de commande d'un dispositif de chauffage et/ou de climatisation et/ou d'aération et/ou de fermeture et/ou de protection solaire et/ou d'occultation.

Selon l'invention, une fenêtre comprend un cadre de vitrage et un vitrage au moins partiellement recouvert d'un film photovoltaïque transparent. La fenêtre comprend des éléments matériels et logiciels de mise en oeuvre des étapes du procédé défini précédemment.

Selon l'invention, un système domotique comprend un dispositif de gestion thermique d'un bâtiment et une fenêtre définie précédemment, le système comprenant des éléments matériels et logiciels de mise en oeuvre des étapes du procédé défini précédemment.

L'invention porte encore sur un programme informatique comprenant un moyen de code de programme informatique adapté à la réalisation des phases et/ou étapes du procédé de fonctionnement défini précédemment, lorsque le programme tourne sur un ordinateur.

L'invention sera mieux comprise à la lecture de la description qui va suivre, donnée uniquement à titre d'exemple et faite en se référant aux dessins annexés sur lesquels :
La figure 1 représente un schéma d'un mode de réalisation d'un système domotique comprenant un mode de réalisation d'une fenêtre selon l'invention.
La figure 2 représente sous forme de schéma un mode d'exécution d'un procédé de fonctionnement d'un système selon l'invention.

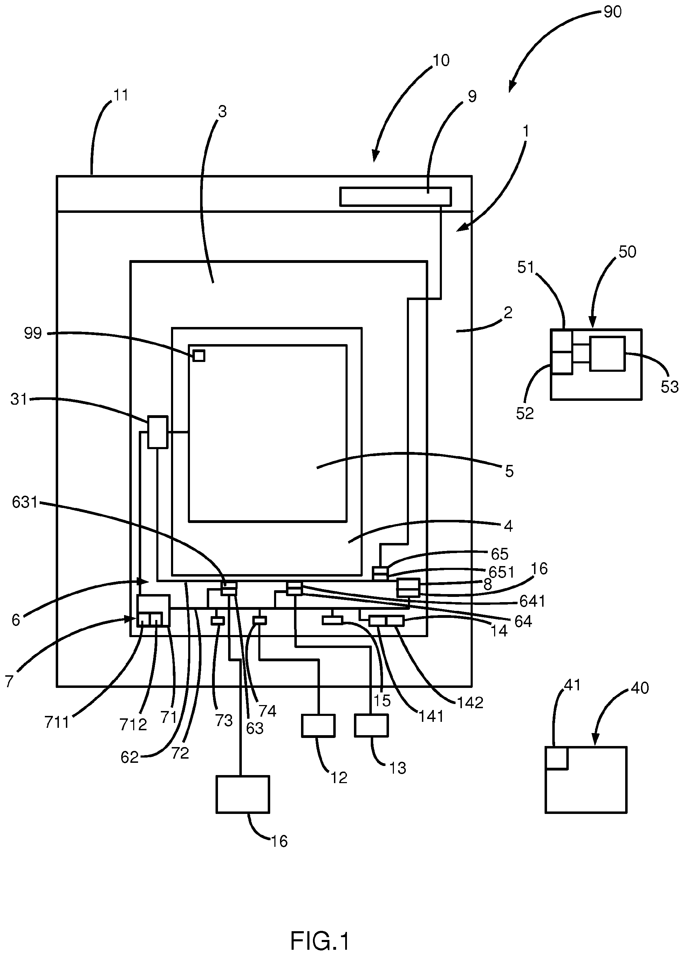

Un mode de réalisation d'un système domotique 90 est décrit ci-après en référence à la figure 1.

Le système 90 domotique comprend :
- une fenêtre 1, et
- un dispositif 71 ; 50 de gestion thermique d'un bâtiment, et
- au moins un équipement domotique 40 comme un dispositif de chauffage et/ou de climatisation et/ou d'aération et/ou de fermeture et/ou de protection solaire et/ou d'occultation, au moins un dispositif pouvant par exemple être un équipement 11 domotique de fermeture, de protection solaire ou d'occultation, comme une porte, un volet, un store, un rideau ou un écran, l'équipement comprenant un actionneur, et
- éventuellement, un équipement électronique 12, 13 comme un capteur ou un ordinateur ou un téléphone ou un équipement multimédia connecté au dispositif 6 de distribution d'énergie électrique et/ou un dispositif 7 de communication d'informations.

Dans le mode de réalisation représenté, l'actionneur 9 est par exemple un actionneur d'un store 11 ou d'un volet roulant 11 monté au niveau de la fenêtre, notamment monté au dessus de la fenêtre. Ainsi, l'équipement 11 permet d'assurer une fonction au niveau de la fenêtre, voire au niveau du vitrage de la fenêtre.

L'actionneur 9 peut être connecté à un dispositif 6 de distribution d'énergie électrique et/ou à un dispositif 7 de communication d'informations.

La fenêtre 1 comprend un cadre 2, 3 de vitrage et un vitrage 4. Le cadre comprend un cadre de dormant et/ou un cadre de battant. Dans le cas d'une fenêtre à battant mobile entre une position fermée et une position ouverte, le cadre comprend un cadre 2 de dormant et un cadre 3 de battant. Dans le cas d'une fenêtre à vitrage fixe, le cadre comprend un unique cadre de dormant.

Le cadre comprend un dispositif 6 de distribution d'énergie électrique et/ou un dispositif 7 de communication d'informations. Dans le mode de réalisation de la figure 1, le cadre comprend un dispositif 6 de distribution d'énergie électrique et un dispositif 7 de communication d'informations.

Le vitrage est complètement ou partiellement recouvert d'un film photovoltaïque transparent 5 au moins connecté au dispositif de distribution d'énergie électrique. Par « film photovoltaïque transparent », on entend un film permettant de laisser passer la majeure partie, par exemple au moins 70%, de l'intensité d'un rayonnement visible. Le film peut recouvrir la totalité du vitrage. Ainsi, le film peut être disposé sur toute une face intérieure ou extérieure du vitrage. Alternativement, le film peut ne recouvrir que partiellement le vitrage. Par exemple, le film peut ne recouvrir qu'une partie inférieure ou qu'une partie supérieure du vitrage. La connexion du film au dispositif de distribution d'énergie électrique permet au film de fournir l'énergie électrique qu'il convertit à partir du rayonnement lumineux au dispositif de distribution d'énergie électrique.

Le cadre, notamment le cadre 2 de dormant et/ou le cadre 3 de battant, inclut un élément 8 de stockage d'énergie électrique connecté au moins au dispositif de distribution d'énergie électrique. Cet élément de stockage d'énergie comprend par exemple une batterie. Cet élément est donc chargé comme vu précédemment par l'énergie électrique issue du film. Cette énergie électrique est transmise à l'élément de stockage via le dispositif 6 de distribution d'énergie électrique.

De préférence, l'élément de stockage d'énergie est implanté du côté intérieur de la fenêtre, c'est-à-dire séparé de l'extérieur par une barrière thermique mise en place dans la fenêtre. En effet, les éléments de stockage de type batterie sont sensibles aux variations de température. Ainsi, du côté intérieur relativement à la barrière thermique, l'élément de stockage est protégé contre les variations importantes de température. Sa durée de vie est donc augmentée. De plus, les opérations de maintenance sont facilitées. Préférentiellement, l'élément de stockage d'énergie est placé à l'intérieur du cadre de la fenêtre pour favoriser l'esthétique de la fenêtre. Toutefois, dans ce cas, l'élément de stockage d'énergie est fixé à la partie intérieure du cadre et est séparé de la face extérieure par une lame d'air ou tout autre matériau isolant thermique. Une trappe d'accès à cet élément de stockage d'énergie peut être formée dans le but de faciliter la maintenance de cet élément.

La fenêtre, en particulier le cadre, notamment le cadre 2 de dormant et/ou le cadre 3 de battant, inclut un élément 15 d'émission d'informations. Notamment, l'élément d'émission d'informations peut être un élément d'émission d'une information de niveau de charge de l'élément de stockage d'énergie électrique, de valeur d'un paramètre électrique issu du film photovoltaïque ou de valeur d'un flux thermique traversant le vitrage de la fenêtre. L'élément d'émission d'informations peut aussi être un élément d'émission d'ordres de commande à destination d'autres dispositifs ou équipements domotiques. L'élément 15 d'émission d'informations peut être un émetteur de signaux électromagnétiques, notamment un émetteur radio.

Le dispositif 6 de distribution d'énergie électrique comprend des premiers conducteurs électriques 62 ou un bus d'alimentation permettant de relier le film à la batterie et permettant également de relier le dispositif à un ou plusieurs équipements différents, en particulier à l'équipement domotique 11, plus précisément à l'actionneur 9 de l'équipement domotique 11. Pour ce faire, le dispositif de distribution d'énergie électrique comprend au moins une fiche 63, 64, 65 ou connecteur relié aux premiers conducteurs électriques. Cette fiche ou ce connecteur permet, à l'aide d'une fiche ou d'un connecteur complémentaire, la connexion électrique à un équipement domotique 11 ou à d'autres équipements électroniques 13, 16 comme un capteur ou un ordinateur ou un téléphone ou un équipement multimédia.

Avantageusement, des interrupteurs commandés 631, 641 et 651 sont intercalés entre les fiches ou connecteurs et les premiers conducteurs électriques 62. Ainsi, les équipements domotiques peuvent être sélectivement connectés et déconnectés des conducteurs électriques 62 et donc du dispositif de distribution d'énergie électrique. Alternativement, la fenêtre peut être munie d'une unité logique de traitement 71 susceptible de communiquer avec d'autres éléments via un élément de communication radio. Les interrupteurs 631, 641 et 651 peuvent être placés sur la même carte électronique de commande que l'unité logique de traitement. Les interrupteurs peuvent être des relais, des transistors ou à base de toute autre technologie équivalente permettant de mettre sous tension un équipement. De la même manière, ces interrupteurs peuvent être placés sur les équipements eux-mêmes toujours sous la forme de relais ou de transistor ou de toute autre technologie équivalente.

La fenêtre, notamment le dispositif 6 de distribution d'énergie électrique, comprend un élément 31 de détermination d'au moins une valeur de paramètre électrique issu du film photovoltaïque. La valeur de paramètre électrique peut être une valeur de tension et/ou d'intensité aux bornes du film photovoltaïque ou aux bornes d'une partie du film photovoltaïque. La valeur de tout autre paramètre électrique pertinent peut être déterminée. L'élément de détermination 31 peut être un élément de mesure. De préférence, l'élément de détermination est relié à l'unité logique de traitement.

Le dispositif 7 de communication d'informations comprend des deuxièmes conducteurs 72 ou un bus de communication permettant la communication d'informations entre différents éléments du système, en particulier entre différents éléments de la fenêtre. Pour ce faire, le dispositif de distribution d'énergie électrique comprend au moins une fiche 73, 74 ou connecteur relié aux deuxièmes conducteurs électriques. Cette fiche ou ce connecteur permet, à l'aide d'une fiche ou d'un connecteur complémentaire, la connexion à un équipement domotique autonome comme un capteur 12. Le dispositif de communication d'information comprend encore de préférence l'unité logique de traitement 71 et/ou l'élément 15 d'émission d'informations et/ou une interface homme-machine 14 et/ou un élément 16 de surveillance de l'élément de stockage d'énergie électrique, notamment un élément de détermination de la charge de l'élément de stockage d'énergie électrique.

L'unité logique de traitement 71 comprend par exemple une table 711 dans laquelle sont stockées des valeurs de paramètre électrique associées des valeurs de flux thermique traversant le vitrage de la fenêtre. Alternativement ou complémentairement, l'unité logique de traitement 71 peut comprendre un élément de calcul 712 permettant de calculer une valeur de flux thermique traversant le vitrage de la fenêtre en utilisant une valeur de paramètre électrique issu du film photovoltaïque.

L'interface homme-machine 14 comprend un élément 141 de saisie d'informations et/ou un élément 142 de signification d'informations, notamment d'affichage d'information. Avantageusement, l'interface peut être un écran tactile. Cette interface permet à un utilisateur d'interagir avec la fenêtre, voire avec le système. L'élément de saisie d'informations peut comprendre au moins un capteur acoustique et/ou vibratoire, notamment au moins un capteur acoustique et/ou vibratoire disposé dans le cadre. L'au moins un capteur acoustique et/ou vibratoire est avantageusement apte à détecter des chocs sur le vitrage.

L'élément de saisie d'informations peut comprendre au moins un élément d'interprétation apte à convertir le signal issu de l'au moins un capteur acoustique en un signal d'information.

L'élément de signification d'information peut comprendre un élément d'affichage d'une information visuelle. Cet élément d'affichage peut comprendre un élément d'émission d'un signal lumineux comme une diode électroluminescente, notamment un élément d'émission d'un signal lumineux dans l'épaisseur du vitrage. Alternativement ou complémentairement, l'élément d'affichage d'une information visuelle peut comprendre un élément d'affichage du type à encre électronique.

L'élément 16 de détermination de niveau de charge de l'élément 8 de stockage d'énergie électrique peut par exemple réaliser une détermination du niveau de charge par estimation ou par mesure. Cette détermination est réalisée notamment par utilisation de valeurs de paramètres physico-chimiques de l'élément de stockage.

Au moins une fiche ou connecteur 63, 64, 65, 73, 74 peut être du type USB. Avantageusement, les fiches ou connecteurs peuvent être fixées sur un rail solidaire, en particulier fixé au cadre du battant ou au cadre du dormant. Avantageusement, au moins une fiche ou connecteur peut être mobile, notamment mobile en translation longitudinale relativement au rail. Pour ce faire, la fiche peut être montée sur un charriot mobile relativement au cadre, le charriot étant notamment guidé dans un guidage prévu sur le cadre. De préférence, au moins une fiche est montée sur le cadre. En particulier, au moins une fiche est montée apparente sur le cadre, une fois la fenêtre montée.

La fiche peut aussi consister en un rail de fixation mécanique et de connexion électrique.

Les interrupteurs commandés 631, 641 et 651 sont de préférence reliés au dispositif 7 de communication d'informations. Ainsi, l'unité logique de traitement permet la commande de la connexion et de la déconnexion des équipements domotiques du dispositif de distribution d'énergie en fonction d'informations auxquelles elle a accès, notamment en fonction d'une information de charge de l'élément de stockage.

Alternativement, au niveau du dispositif de communication d'informations, d'autres moyens de communication peuvent être utilisés, comme des éléments de communication non filaires, la communication pouvant être réalisée par ondes électromagnétiques, notamment radio entre les différents éléments.

Le dispositif 71 de gestion thermique est par exemple inclus dans la fenêtre. C'est par exemple le cas lorsque ce dispositif est constitué par l'unité logique de traitement 71 ou au moins les fonctions de ce dispositif sont assurées par l'unité logique de traitement 71. Dans ce cas, des ordres de commandes peuvent être générés par l'unité logique de traitement puis émis par l'élément de communication 15 à destination des équipements domotiques concernés. Alternativement, le dispositif 50 de gestion thermique est par exemple externe à la fenêtre. Dans ce cas, des informations peuvent être reçues par le dispositif de gestion thermique grâce à un récepteur de signaux 51. Des ordres de commandes sont alors générés par le dispositif de gestion thermique, notamment par une unité logique de traitement 53 du dispositif. Les ordres de commande sont ensuite émis par un émetteur d'ordres 52 à destination des équipements domotiques concernés.

Dans les deux cas, les ordres sont générés en prenant en compte les flux thermiques ou apports thermiques au niveau du ou des vitrages.

Ces ordres de commandes sont reçus par le dispositif domotique 40 ou les dispositifs auxquels ils sont destinés. Pour ce faire, le dispositif domotique comprend un récepteur d'ordres 41.

La fenêtre, en particulier l'unité logique de traitement 71, comprend des moyens matériels et/ou logiciels permettant de mettre en oeuvre le procédé de fonctionnement selon l'invention, notamment de mettre en oeuvre les étapes du procédé de fonctionnement selon l'invention. Les éléments logiciels peuvent comprendre des programmes informatiques ou des modules logiciels. La fenêtre comprend ainsi par exemple un élément de détermination de la charge de l'élément de stockage, un élément de sélection automatique d'un sous-ensemble d'équipements domotiques parmi un ensemble d'éléments domotiques et des éléments de connexion et/ou de déconnexion des équipements domotiques de l'élément de stockage.

Avantageusement, le dispositif 6 de distribution d'énergie électrique et le dispositif 7 de communication d'informations peuvent être réalisés par sensiblement les mêmes éléments matériels. Dans ce cas, les informations peuvent consister en des signaux électriques circulant sur les conducteurs d'alimentation en utilisant une technologie de courants porteurs en ligne.

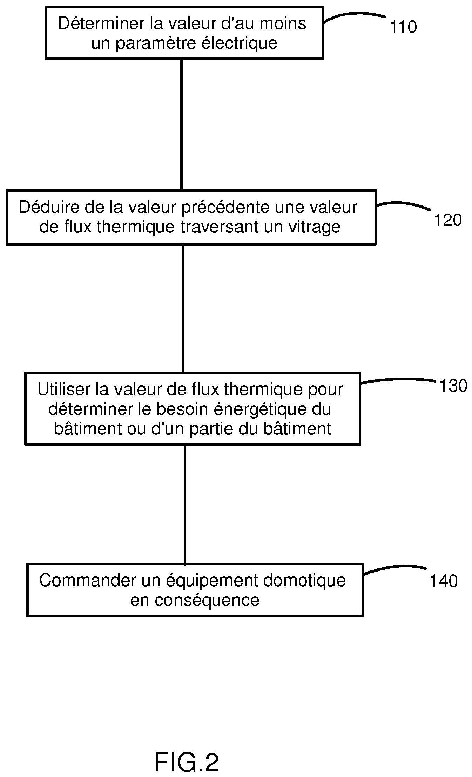

Un mode d'exécution d'un procédé de fonctionnement selon l'invention est décrit ci-après en référence à la figure 2. Le procédé permet de régir le fonctionnement de la fenêtre selon l'invention et en particulier le fonctionnement de la fenêtre telle que décrit précédemment. Le procédé permet aussi de régir le fonctionnement du système domotique selon l'invention et en particulier le fonctionnement du système domotique tel que décrit précédemment.

Globalement, le procédé comprend une étape de détermination d'au moins une valeur d'un paramètre électrique issu du film photovoltaïque et une étape de détermination d'une valeur d'un flux thermique traversant le vitrage de la fenêtre, en utilisant l'au moins une valeur de paramètre électrique.

Dans une première étape 110, on détermine la valeur d'au moins un paramètre électrique issu du film photovoltaïque. Cette détermination peut être réalisée par mesure ou par estimation ou encore par calcul à partir d'une mesure ou d'une estimation. L'au moins une valeur déterminée peut inclure une valeur de tension et/ou d'intensité aux bornes du film photovoltaïque ou aux bornes d'une partie du film photovoltaïque. Elle peut complémentairement ou alternativement inclure la valeur de tout autre paramètre électrique pertinent. Cette détermination peut être réalisée intégralement au niveau de l'élément de détermination 31.

Dans une deuxième étape 120, on déduit la valeur du flux thermique traversant le vitrage en utilisant la valeur de l'au moins un paramètre électrique déterminé à l'étape précédente. Cette déduction peut être réalisée par lecture dans une table 711 d'une valeur de flux thermique associée à l'au moins une valeur de paramètre électrique. Cette table peut être renseignée en utilisant des résultats expérimentaux. Alternativement, cette déduction peut être réalisée par calcul utilisant l'au moins une valeur de paramètre électrique, notamment grâce à l'élément de calcul 712. On peut par exemple effectuer un calcul intégrant la mesure de l'intensité d'un courant issu du film photovoltaïque et les spécifications du fournisseur du film photovoltaïque.

De préférence, l'étape de déduction de la valeur du flux thermique intègre une correction. Cette correction peut dépendre de la hauteur du soleil (que l'on connaît par la date, l'heure, l'orientation de la fenêtre, et la position géographique de la maison) et des propriétés optiques du film photovoltaïque.

Afin d'éviter de prendre en considération un obscurcissement temporaire du ciel, par exemple lors du passage d'un nuage, une valeur de cumul du flux thermique sur une période de temps prédéterminée peut être réalisée au niveau de l'unité logique de traitement 71. La période de temps prise en compte pourra par exemple être comprise entre 15 et 60 minutes et préférentiellement égale à 30 minutes.

La valeur de cumul pourra être obtenue par l'intégration des valeurs de l'au moins un paramètre électrique mesuré au niveau du film photovoltaïque, puis par la déduction à partir d'une table 711 de correspondance ou par la même formule de calcul 712.

Pour l'ensemble de ce document, la valeur du flux thermique peut être la valeur instantanée obtenue à partir des mesures d'au moins un paramètre électrique au niveau du film photovoltaïque ou une valeur cumulée de flux thermique.

Dans une troisième étape 130, on utilise la valeur du flux thermique pour déterminer un besoin énergétique du bâtiment ou d'une partie du bâtiment. Pour ce faire, la valeur du flux thermique déterminée est envoyée vers le dispositif de gestion thermique du bâtiment. Cette valeur de flux thermique permet de définir un ou plusieurs ordres de commande d'un équipement domotique comme un dispositif de chauffage et/ou de climatisation et/ou d'aération et/ou de fermeture et/ou de protection solaire et/ou d'occultation.

Dans une quatrième étape 140, on commande un ou plusieurs équipements domotiques. Cette commande est réalisée par l'émission et l'exécution des ordres de commande par le ou les équipements domotiques.

Les éléments domotiques peuvent inclure un équipement domotique motorisé de fermeture, de protection solaire ou d'occultation, comme une porte, un volet, un store, un rideau, un écran, et/ou un dispositif de communication d'informations et/ou un équipement électronique comme un capteur.

Avantageusement, la valeur de flux thermique traversant le vitrage peut être corrigée en fonction d'une température mesurée, notamment une température mesurée sur le vitrage. Autrement dit, l'étape de détermination de la valeur du flux thermique traversant le vitrage de la fenêtre utilise avantageusement une valeur de température du vitrage ou du film photovoltaïque.

En effet, pour la plupart des technologies photovoltaïques, une température élevée créé une perte de performance. A l'inverse, les modules photovoltaïques ont leurs performances au maximum lorsque la température est basse (y compris négative). Ceci est aussi valable pour le film photovoltaïque. Ainsi, si on utilise une mesure électrique du film photovoltaïque pour évaluer l'ensoleillement (et pour ensuite calculer le flux thermique), il est intéressant d'appliquer une correction vis-à-vis de la température.

Par exemple, sous un ensoleillement de 500W/m² à 10°C si le courant issu d'un film photovoltaïque est de 100mA, le même film photovoltaïque sous le même ensoleillement de 500W/m² à 40°C peut ne fournir que 70mA. Il est donc préférable de connaître la température, notamment la température du film photovoltaïque, pour déterminer le flux thermique traversant le vitrage sur la base du courant issu du film photovoltaïque.

Ainsi, il est intéressant d'utiliser une sonde de température ou un capteur de température 99 sur le vitrage, de préférence au niveau du film photovoltaïque, soit du même côté du vitrage que le film photovoltaïque, afin de pouvoir réaliser une correction du calcul en fonction de la température.

## Revendications

1. Procédé de fonctionnement d'une fenêtre (1) pour bâtiment, la fenêtre comprenant un cadre (2, 3) de vitrage et un vitrage (4) au moins partiellement recouvert d'un film photovoltaïque (5) transparent, le procédé comprenant une étape de détermination d'au moins une valeur d'un paramètre électrique issu du film photovoltaïque et une étape de détermination d'une valeur d'un flux thermique traversant le vitrage de la fenêtre, en utilisant l'au moins une valeur de paramètre électrique.

2. Procédé de fonctionnement selon la revendication précédente, **caractérisé en ce que** l'étape de détermination d'au moins une valeur de paramètre électrique comprend la détermination d'une valeur de tension et/ou d'intensité aux bornes du film photovoltaïque ou aux bornes d'une partie du film photovoltaïque.

3. Procédé de fonctionnement selon la revendication 1 ou 2, **caractérisé en ce que** l'étape de détermination de la valeur du flux thermique traversant le vitrage de la fenêtre comprend une lecture dans une table d'une valeur de flux thermique associée à l'au moins une valeur de paramètre électrique.

4. Procédé de fonctionnement selon l'une des revendications précédentes, **caractérisé en ce que** l'étape de détermination de la valeur du flux thermique traversant le vitrage de la fenêtre comprend un calcul utilisant l'au moins une valeur de paramètre électrique.

5. Procédé de fonctionnement selon l'une des revendications précédentes, **caractérisé en ce qu'**il comprend une étape d'émission de la valeur du flux thermique déterminée vers un dispositif (71 ; 50) de gestion thermique du bâtiment, la valeur déterminée de flux thermique étant destinée à être utilisée pour définir un ordre de commande d'un dispositif (40) de chauffage et/ou de climatisation et/ou d'aération et/ou de fermeture et/ou de protection solaire et/ou d'occultation.

6. Procédé de fonctionnement selon l'une des revendications précédentes, **caractérisé en ce que** l'étape de détermination de la valeur du flux thermique traversant le vitrage de la fenêtre utilise une valeur de température du vitrage ou du film photovoltaïque.

7. Procédé de fonctionnement d'un système domotique (90) comprenant un système (71 ; 40) de gestion thermique d'un bâtiment et une fenêtre (1) comprenant un cadre (2, 3) de vitrage et un vitrage (4) au moins partiellement recouvert d'un film photovoltaïque (5) transparent, le procédé comprenant une étape de détermination d'au moins une valeur d'un paramètre électrique issu du film photovoltaïque, une étape de détermination d'une valeur d'un flux thermique traversant le vitrage de la fenêtre, en utilisant l'au moins une valeur de paramètre électrique et une étape de définition d'un ordre de commande d'un dispositif (40) de chauffage et/ou de climatisation et/ou d'aération et/ou de fermeture et/ou de protection solaire et/ou d'occultation.

8. Fenêtre (1) comprenant un cadre (2, 3) de vitrage et un vitrage (4) au moins partiellement recouvert d'un film photovoltaïque transparent (5), la fenêtre comprenant des éléments matériels et logiciels (31, 71, 711, 712, 15, 99) de mise en oeuvre des étapes du procédé selon l'une des revendications 1 à 6.

9. Système domotique (90) comprenant un dispositif (50) de gestion thermique d'un bâtiment et une fenêtre (1) selon la revendication précédente, le système comprenant des éléments matériels et logiciels (31, 71, 711, 712, 15, 50, 51, 52, 53) de mise en oeuvre des étapes du procédé selon la revendication 7.

## Patentansprüche

1. Verfahren zur Bedienung eines Fensters (1) für ein Gebäude, wobei das Fenster einen Verglasungsrahmen (2, 3) und eine Verglasung (4) umfasst, die zumindest teilweise mit einem transparenten Photovoltaikfilm (5) bedeckt ist, wobei das Verfahren einen Schritt der Bestimmung mindestens eines Werts eines elektrischen Parameters, der von dem Photovoltaikfilm ausgeht, und einen Schritt der Bestimmung eines Werts eines Wärmestroms, der durch die Verglasung des Fensters hindurchgeht, umfasst, wobei der mindestens eine Wert eines elektrischen Parameters verwendet wird.

2. Bedienungsverfahren nach dem vorhergehenden Anspruch, **dadurch gekennzeichnet, dass** der Schritt der Bestimmung mindestens eines Werts eines elektrischen Parameters die Bestimmung eines Spannungswerts und/oder eines Stromstärkewerts an den Klemmen des Photovoltaikfilms oder an den Klemmen eines Teils des Photovoltaikfilms umfasst.

3. Bedienungsverfahren nach Anspruch 1 oder 2, **dadurch gekennzeichnet, dass** der Schritt der Bestimmung des Werts des durch die Verglasung des Fensters hindurchgehenden Wärmestroms ein Ablesen eines Wärmestromwerts, der dem mindestens einen elektrischen Parameterwert zugeordnet ist, in einer Tabelle umfasst.

4. Bedienungsverfahren nach einem der vorhergehenden Ansprüche, **dadurch gekennzeichnet, dass** der Schritt der Bestimmung des Werts des durch die Verglasung des Fensters hindurchgehenden Wärmestroms eine Berechnung umfasst, die den mindestens einen elektrischen Parameterwert verwendet.

5. Bedienungsverfahren nach einem der vorhergehenden Ansprüche, **dadurch gekennzeichnet, dass** es einen Schritt des Sendens des Werts des bestimmten Wärmestroms zu einer Thermomanagementvorrichtung (71; 50) des Gebäudes umfasst, wobei der bestimmte Wärmestromwert dazu bestimmt ist, verwendet zu werden, um einen Steuerbefehl einer Vorrichtung (40) zum Heizen und/oder Kühlen und/oder Belüften und/oder Schließen und /oder Sonnenschutz und/oder zur Verdunkelung zu definieren.

6. Bedienungsverfahren nach einem der vorhergehenden Ansprüche, **dadurch gekennzeichnet, dass** der Schritt der Bestimmung des Werts des durch die Verglasung des Fensters hindurchgehenden Wärmestroms einen Temperaturwert der Verglasung oder des Photovoltaikfilms verwendet.

7. Verfahren zur Bedienung eines Haustechniksystems (90), umfassend ein Thermomanagementsystem (71; 40) für ein Gebäude und ein Fenster (1), umfassend einen Verglasungsrahmen (2, 3) und eine Verglasung (4), die zumindest teilweise mit einem transparenten Photovoltaikfilm (5) bedeckt ist, wobei das Verfahren einen Schritt der Bestimmung mindestens eines Werts eines elektrischen Parameters, der von dem Photovoltaikfilm ausgeht, einen Schritt der Bestimmung eines Werts eines Wärmestroms, der durch die Verglasung des Fensters hindurchgeht, wobei der mindestens eine Wert eines elektrischen Parameters verwendet wird, und einen Schritt der Definition eines Steuerbefehls einer Vorrichtung (40) zum Heizen und/oder Kühlen und/oder Belüften und/oder Schließen und /oder Sonnenschutz und/oder zur Verdunkelung umfasst.

8. Fenster (1), umfassend einen Verglasungsrahmen (2, 3) und eine Verglasung (4), die zumindest teilweise mit einem transparenten Photovoltaikfilm (5) bedeckt ist, wobei das Fenster Hardware- und Software-Elemente (31, 71, 711, 712, 15, 99) für den Einsatz der Schritte des Verfahrens nach einem der Ansprüche 1 bis 6 umfasst.

9. Haustechniksystem (90), umfassend eine Thermomanagementvorrichtung (50) und ein Fenster (1) nach dem vorhergehenden Anspruch, wobei das System Hardware- und Software-Elemente (31, 71, 711, 712, 15, 50, 51, 52, 53) für den Einsatz der Schritte des Verfahrens nach Anspruch 7 umfasst.

## Claims

1. Method for operating a window (1) for a building, the window comprising a glazing frame (2, 3) and a glazing unit (4) at least partially covered with a transparent photovoltaic film (5), the method comprising a step of determination of at least one value of an electrical parameter deriving from the photovoltaic film and a step of determination of a value of a heat flux passing through the glazing of the window, by using the at least one electrical parameter value.

2. Operating method according to the preceding claim, **characterized in that** the step of determination of at least one electrical parameter value comprises the determination of a voltage and/or current value at the terminals of the photovoltaic film or at the terminals of a part of the photovoltaic film.

3. Operating method according to Claim 1 or 2, **characterized in that** the step of determination of the value of the heat flux passing through the glazing of the window comprises reading in a table a heat flux value associated with the at least one electrical parameter value.

4. Operating method according to one of the preceding claims, **characterized in that** the step of determination of the value of the heat flux passing through the glazing of the window comprises a calculation using the at least one electrical parameter value.

5. Operating method according to one of the preceding claims, **characterized in that** it comprises a step of transmission of the determined heat flux value to a thermal management device (71; 50) of the building, the determined heat flux value being intended to be used to define a command controlling a heating and/or air conditioning and/or ventilation and/or closure and/or solar protection and/or occulting device (40).

6. Operating method according to one of the preceding claims, **characterized in that** the step of determination of the value of the heat flux passing through the glazing of the window uses a temperature value of the glazing or of the photovoltaic film.

7. Method for operating a home automation system (90) comprising a thermal management system (71; 40) of a building and a window (1) comprising a glazing frame (2, 3), and a glazing unit (4) at least partially covered with a transparent photovoltaic film, the method comprising a step of determination of at least one value of an electrical parameter deriving from the photovoltaic film, a step of determination of a value of a heat flux passing through the glazing of the window, by using the at least one electrical parameter value and a step of definition of a command controlling a heating and/or air conditioning and/or ventilation and/or closure and/or solar protection and/or occulting device (40).

8. Window (1) comprising a glazing frame (2, 3) and a glazing unit (4) at least partially covered with a transparent photovoltaic film (5), the window comprising hardware and software elements (31, 71, 711, 712, 15, 99) for implementing the steps of the method according to one of Claims 1 to 6.

9. Home automation system (90) comprising a thermal management device (50) of a building and a window (1) according to the preceding claim, the system comprising hardware and software elements (31, 71, 711, 712, 15, 50, 51, 52, 53) for implementing the steps of the method according to Claim 7.
